# EUROPÄISCHE PATENTSCHRIFT

(11) **EP 3 696 976 B1**
(45) Veröffentlichungstag und Bekanntmachung des Hinweises auf die Patenterteilung: **25.06.2025**
(21) Anmeldenummer: 20150885.0
(22) Anmeldetag: 09.01.2020
(51) Int. Cl.: H02P 6/26, H03K 17/0814

(54) **ENERGIERÜCKGEWINNUNGSSCHALTUNG**
ENERGY RECOVERY CIRCUIT
CIRCUIT DE RÉCUPÉRATION D'ÉNERGIE

(30) Priorität: 12.02.2019 DE 102019201775
(43) Veröffentlichungstag der Anmeldung: 19.08.2020
(73) Patentinhaber: Bühler Motor GmbH, 90459 Nürnberg (DE)
(72) Erfinder: Weiss, Jens, 90762 Fürth (DE); Walter, Gerhard, 91126 Rednitzhembach (DE)

(56) Entgegenhaltungen:
- EP-A2- 0 070 158
- WO-A2-2014/021911
- DE-A1- 102006 010 402
- DE-A1- 3 436 433
- DE-T2- 69 219 812
- US-A1- 2018 367 133

## Beschreibung

Die Erfindung betrifft eine Energierückgewinnungsschaltung eines Elektromotors mit einer einphasigen Wicklung (3), bestehend aus zwei Teilspulen (5) mit Mittenabgriff (7), wobei die beiden Wicklungsenden der Teilspulen (5) über jeweils ein Schaltelement (8) mit Masse (10) verbunden sind.

Eine Kommutierung eines gattungsgemäßen Elektromotors mit einphasiger Wicklung wird so realisiert, dass die beiden Schaltelemente abwechselnd geschaltet werden, synchron zur elektrischen Drehzahl des Motors. Durch das abwechselnde Schalten wird ein Drehfeld im Stator des Elektromotors erzeugt, welches einen Permanentmagnetrotor mitschleppt. Eine derartige Schaltung wird auch als M-Schaltung bezeichnet. Beim Umschalten der Motorwicklungen muss die in der jeweiligen Teilspule gespeicherte elektrische Energie abgebaut werden. Da bei der genannten Verschaltung kein Freilauf vorhanden ist, steigt die Spannung am Schaltelement bis auf dessen Durchbruchspannung (Avalanche-Durchbruch) an und der Strom fließt über dieses Schaltelement zur Masse weiter. Dies hat einen steilen Anstieg des Stroms zur Folge. Die Verlustleistung errechnet sich dabei aus der Zeit, in welcher der Puls anliegt, aus der Durchbruchspannung und dem Strom der dabei fließt. Da Avalanche-Durchbrüche sehr energiereich sind werden Bauteile dabei sehr stark thermisch belastet. Die Toleranzen für die thermische Belastbarkeit von Schaltelementen sind aus wirtschaftlichen Gründen sehr begrenzt. Wird eine höhere Motorleistung angestrebt muss mit der thermischen Zerstörung der Bauteile gerechnet werden. Die beschriebenen Avalanche-Durchbrüche erzeugen einen großen Teil der Gesamtverluste und verringern damit den Gesamtwirkungsgrad erheblich.

WO 2014/021911 A2 offenbarteinen Controller und ein Verfahren für Elektromotoren, um die Rück-EMK reduziert umfassend einen Rückgewinnungsspeicher für Energie, die bei der Unterbrechung der Stromzufuhr zu mindestens einer Wicklung des Elektromotors entsteht beim Einsatz eines Schaltungsunterbrechers, der die Energiezufuhr zum Motor unterbricht.

DE 10 2006 010 402 A1 beschreibt eine Vorrichtung und ein Verfahren zur Erzeugung einer stabilisierten Betriebskleinspannung unter Verwendung der Motorwicklung stellt diese ohne weitere Wickelgüter mit einem Kondensator, der in Reihe mit einer Diode parallel zur Motorwicklung geschaltet ist und mit dem Entladestrom der zuvor über einen Schalter aus einer Spannungsquelle geladenen Motorwicklung geladen wird.

Die Schaltelemente, wie MOSFETs werden in der Regel über einen Mikrocontroller angesteuert. Die zur Verfügung stehende Spannung ist aber nicht ausreichend, um die MOSFETs richtig und definiert durchzuschalten.

Aufgabe der Erfindung ist es daher bei einem gattungsgemäßen Elektromotor für einen höheren Wirkungsgrad, eine bessere und definierte Beschaltung der Wicklungsschaltelemente, für eine thermische Entlastung der Schaltelemente, für eine verbesserte Laufruhe, eine verringerte Erwärmung der Leiterplatte, ein verbessertes EMV-Verhalten, ein robusteres Design der Gesamtschaltung, eine gezielte Leitung der Verluste und für einen zusätzlichen Schutz vor sonstigen Überspannungspulsen aus einem Versorgungsnetz zu sorgen.

Diese Aufgabe wird erfindungsgemäß durch die Merkmale des Anspruchs 1 gelöst. Dadurch dass im Betrieb ein Teil der in den Teilspulen (5) gespeicherten Energie beim Abschalten des Schaltelements (8) über eine Diode (24) in einen Speicherkondensator (20) geleitet wird, welcher dadurch aufgeladen wird und diese rückgewonnene Energie zwischenspeichert, kann ein Teil der Abschaltenergie von dem Schaltelement abgeleitet werden und dieses thermisch entlastet werden.

Weiterbildungen der Erfindung werden in den Unteransprüchen näher erläutert. Die zwischengespeicherte Energie des aufgeladenen Speicherkondensators (20) erzeugt eine Ausgangsspannung(21), deren Spannungsniveau sich durch Parallelschalten einer Z-Diode zum Speicherkondensator (20) stabilisieren lässt, z. B. auf 15V.

Die Ausgangsspannung (21) dient als Eingangsspannung für eine von der Bordnetzspannung weitgehend unabhängige Anwendung, Schaltung oder Teilschaltung.

Gemäß der Erfindung ist vorgesehen, dass die Ausgangsspannung (21) für den Betrieb einer Treiberschaltung (22) verwendet wird, wobei die Treiberschaltung das Schaltelement (8) schaltet. Das Spannungsniveau liegt dabei deutlich über dem Spannungspegel, üblicher Treiberspannungen. Dadurch lässt sich das Schaltelement definiert schalten, wodurch das Schaltverhalten insgesamt verbessert ist.

Auch der Betrieb eines Verpolschutzes ist durch die Ausgangsspannung (21) möglich, auch zusätzlich zu einer Treiberschaltung.

Der Teil eines Abschaltstroms aus der Teilspule (5), der nicht über die Treiberschaltung (22) oder den Verpolschutz verbraucht werden kann wird gesteuert über ein elektrisches Leistungsbauteil abgeleitet, welches parallel zum Schaltelement (8) geschaltet ist.

Als Leistungsbauteil zur Umwandlung des überschüssigen Abschaltstroms in Wärme wird ein bipolarer Leistungstransistor verwendet.

Die Energierückgewinnungsschaltung kann sehr gut in Elektromotoren zum Antrieb von Kreiselpumpen oder zum Antrieb von Ölnebelabscheidern verwendet werden. In der Regel werden für diese Anwendungen bürstenlose Gleichstrommotoren eingesetzt.

Ausführungsbeispiele der Erfindung werden nachfolgend anhand der Zeichnung näher erläutert. Es zeigen:
Fig. 1 eine Energierückgewinnungsschaltung,
Fig. 2 ein Widerstands/Spannungs-Diagramm eines MOSFETEs und
Fig. 3 eine Variante der Energierückgewinnungsschaltung.

Hinweis: Bezugszeichen mit Index und entsprechende Bezugszeichen ohne Index bezeichnen namensgleiche Einzelheiten in den Zeichnungen und der Zeichnungsbeschreibung. Es handelt sich dabei um die Verwendung in einer anderen Ausführungsform, dem Stand der Technik und/oder die Einzelheit ist eine Variante.

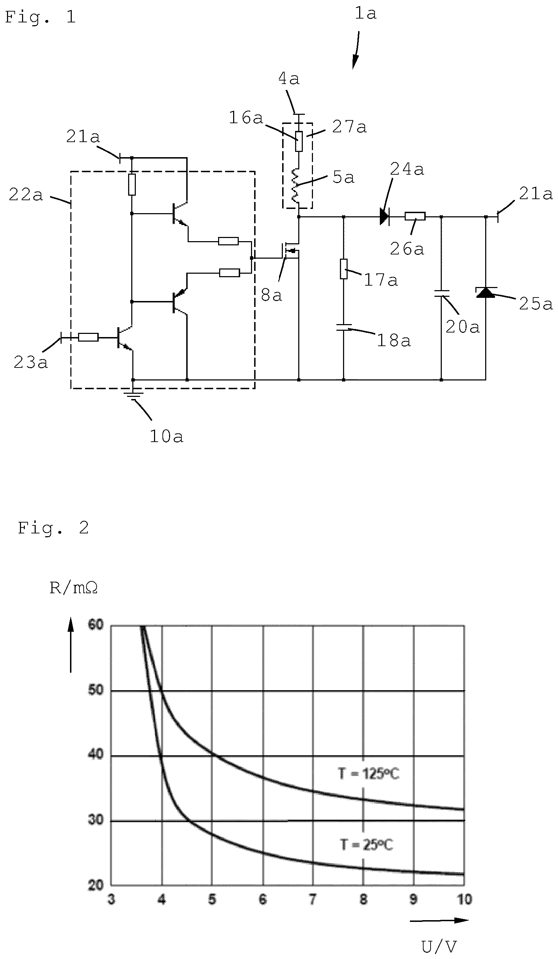

Fig. 1 zeigt ein Beispiel einer Energierückgewinnungsschaltung eines Elektromotors mit einer einphasigen Wicklung, bestehend aus zwei Teilspulen mit Mittenabgriff. In Fig. 1 ist eine Ersatzschaltung 27a mit einer Teilspule 5a und einem Ersatzwiderstand 16a dargestellt. Die Ersatzschaltung 27a stellt nur einen Zweig der Statorwicklung dar. Die Teilspule 5a liegt an der Motorversorgungsspannung 4a an, welche bei einer Kfz-Anwendung in der Regel der Akku-Spannung entspricht. Die Teilspule wird im Betrieb über ein Schaltelement 8a, hier als MOSFET ausgeführt, alternierend ein und ausgeschaltet. Das Schaltelement 8a wird über eine Treiberschaltung 22a betrieben, welche ihrerseits über einen Steuereingang 23a von einer Schaltungslogik gesteuert wird. Ein Treiberversorgungsanschluss 21a liefert die Gate-Spannung des Schaltelements 8a. Die hier zugrunde liegende Wicklungsverschaltung lässt keinen Freilauf zu, deshalb wird beim Abschalten einer Teilspule 5a die darin gespeicherte Energie in die das Schaltelement 8a zurückgeleitet. Beim Abschalten der Teilspule 5a treibt deren Induktivität den Strom weiter in die gleiche Richtung. Dies führt dazu dass die Spannung an der Diode 24a ansteigt bis sie leitfähig wird und ein Teil des Stroms aus der Teilspule 5a über einen Widerstand 26a zu einem Speicherkondensator 20a fließt. Dieser lädt sich auf, so dass an ihm eine Spannung anliegt.

Die Spannung am Schaltelement 8a steigt weiter bis auf dessen Druchbruchspannung an und der Strom fließt im Avalanche-Betrieb über den Kanal des Schalters zur Masse 10a. Der größte Teil der Spulenenergie wird dabei im Schaltelement 8a in Wärme umgewandelt. Ein kleinerer Teil der Spulenenergie wird, wie erwähnt, über die Diode 24a und dem Widerstand 26a auf den Speicherkondensator 20a abgeleitet. Dadurch wird das Schaltelement 8a entlastet. Spannungsspitzen werden durch den Speicherkondensator 20a geglättet. Die Diode 24a verhindert, dass sich der Speicherkondensator 20a über den Spulenzweig wieder entladen kann. Parallel zum Speicherkondensator 20a sorgt eine Z-Diode 25a für eine stabile Spannung von ca. 15V, welche als Treiberspannung an einem Treiberspannungsanschluss 21a zum Betrieb der Treiberschaltung dient. Bei einem Spannungsniveau von 15V lässt sich das Schaltelement definierter und mit weniger Verlusten durchschalten als mit den üblichen 5V aus der Steuerlogik.

Zusätzlich sind ein Snubber-Widerstand 17a und ein Snubber-Kondensator 18a dargestellt, welche ein Snubber-Netzwerk bilden. Dieses bewirkt ein sauberes Schalten der Schaltflanke und hat damit einen positiven Einfluss auf die Verluste in den Transistoren und das EMV-Verhalten.

In Fig. 2 ist ein Widerstand-Gate-Spannungsdiagramm eines MOSFETEs dargestellt, welches den Zusammenhang zwischen dem Drain-Source-Widerstand in Abhängigkeit von der Gate-Source-Spannung bei unterschiedlichen Temperaturen aufzeigt. Der Drain-Source-Widerstand verringert sich im Bereich zwischen 5 und 10 V deutlich und verringert sich bis 15V weiter (hier nicht erkennbar). Bei geringerem Drain-Source-Widerstand wird weniger Wärme erzeugt und der Wirkungsgrad gesteigert. Weiter wird hierdurch der Gradient der Stromspitzen beim Schalten des Schaltelements reduziert, wodurch ein verbessertes Geräusch und EMV-Verhalten erreicht wird. Auch die Durchbruchsspannungsamplitude ist hierdurch begrenzt. Dadurch werden die Anforderungen an die Spannungsfestigkeit der Schaltelemente reduziert. Dies wirkt sich positiv auf den notwendigen Bauraum und auf die Wirtschaftlichkeit der Schaltung aus. Die erzeugte Treiberspannung ist dabei stets hoch genug, um die Leistungstransistoren richtig und definiert durchschalten zu können. Insgesamt lässt sich mit dieser Ausgestaltung der Schaltung ein gegenüber dem Stand der Technik robusteres Design realisieren.

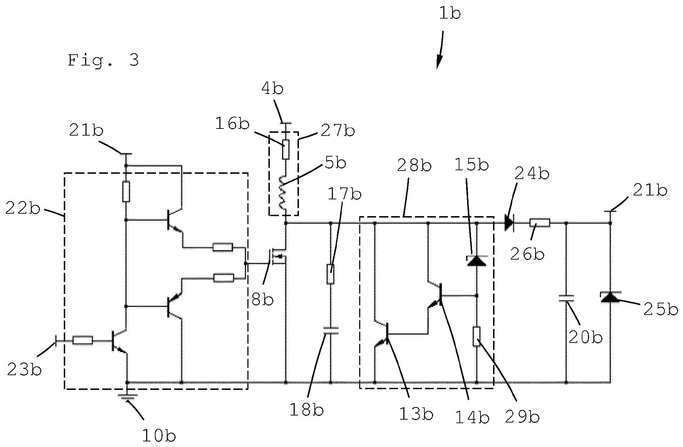

Fig. 3 zeigt eine Variante der Energierückgewinnungsschaltung eines Elektromotors mit einer einphasigen Wicklung gemäß der Erfindung, bestehend aus zwei Teilspulen mit Mittenabgriff (hier ist nur ein Zweig dargestellt). In Fig. 3 ist eine Ersatzschaltung 27b mit einer Teilspule 5b und einem Ersatzwiderstand 16b dargestellt. Die Ersatzschaltung 27b stellt einen Zweig der Statorwicklung mit nur einer Teilspule dar. Die Teilspule 5b liegt an der Motorversorgungsspannung 4b an, welche bei einer Kfz-Anwendung in der Regel der Akku-Spannung entspricht. Die Teilspule 5b wird im Betrieb über ein Schaltelement 8b, hier als MOSFET ausgeführt, alternierend ein und ausgeschaltet. Das Schaltelement 8b wird über eine Treiberschaltung 22b betrieben, welche ihrerseits über einen Steuereingang 23b von einer Schaltungslogik gesteuert wird. Ein Treiberversorgungsanschluss 21b liefert die Gate-Spannung des Schaltelements 8b. Die zugrunde liegende Wicklungsverschaltung lässt keinen Freilauf zu, deshalb wird beim Abschalten der Teilspule 5b die darin gespeicherte Energie zum Schaltelement 8b zurückgeleitet. Beim Abschalten der Teilspule 5b treibt deren Induktivität den Strom weiter in die gleiche Richtung. Dies führt dazu dass die Spannung an der Diode 24b ansteigt bis sie leitfähig wird und ein Teil des Stroms aus der Teilspule 5b über einen Widerstand 26b zu einem Speicherkondensator 20b fließt. Dieser lädt sich auf, so dass an ihm eine Spannung anliegt. Spannungsspitzen werden durch den Speicherkondensator 20b geglättet. Die Diode 24b verhindert, dass sich der Speicherkondensator 20b über den Spulenzweig wieder entladen kann. Parallel zum Speicherkondensator 20b sorgt eine Z-Diode 25b für eine stabile Spannung von ca. 15V, welche als Treiberspannung an einem Treiberspannungsanschluss 21b zum Betrieb der Treiberschaltung dient. Bei einem Spannungsniveau von 15V lässt sich das Schaltelement definierter und mit weniger Verlusten durchschalten als mit den üblichen 5V aus der Steuerlogik.

Ein großer Teil der Energie, welche beim Abschalten der Teilspule 5b frei wird, kann nicht Zwischengespeichert werden und muss in Wärme umgewandelt werden. Um mit dieser entstehenden Wärme nicht das Schaltelement 8b zu belasten ist eine Umleitungsschaltung 28b sinnvoll. Die Umleitungsschaltung 28b besteht aus einer Steuer-Z-Diode 15b, einem Steuerwiderstand 29b, einem bipolaren Leistungstransistor 13b und einem Steuertransistor 14b. Die Basis des bipolaren Leistungstransistors 13b ist mit dem Emitter des Steuertransistors 14b verbunden. Die Basis des Steuertransistors 14b ist mit der Steuer-Z-Diode 15b und dem Steuerwiderstand 29b verbunden. Der Steuerwiderstand 29b dient als Pull-Down-Widerstand und sorgt dafür, dass der Steuertransistor 14b im Grundzustand nichtleitend ist. Bei Auftreten eines Abschaltimpulses und nach Erreichen eines Mindestspannungspegels zieht die Steuer-Z-Diode 15b die Basisspannung des Steuertransistors 14b auf einen Pegel der den Steuertransistor 14b leitend macht. Die überschüssige Abschaltenergie wird dann über den bipolaren Leistungstransistor 13b abgeleitet und in Wärme umgewandelt, welche dann an die Umgebung abgegeben wird.

Insgesamt verhält sich die Umleitungsschaltung 28b wie eine Z-Diode, jedoch sind die Verlustleistungsgrenze und Steuerbarkeit deutlich verbessert. Durch die Höhe des Basisstromes der Transistoren 14b, 13b und durch die Stromverstärkung der Transistoren 14b, 13b kann die Schaltung so angepasst werden, dass die Steilheit der Stromflanke eingestellt werden kann.

Zusätzlich sind ein Snubber-Widerstand 17b und ein Snubber-Kondensator 18b dargestellt, welche ein Snubber-Netzwerk bilden. Dieses bewirkt ein sauberes Schalten der Schaltflanke und hat damit einen positiven Einfluss auf die Verluste in den Transistoren und das EMV-Verhalten.

### Bezugszeichenliste

- 1: Energierückgewinnungsschaltung
- 4: Motorversorgungsspannung (Spannungsquelle)
- 5: Teilspule
- 8: Schaltelement
- 10: Masse
- 13: bipolarer Leistungstransistor
- 14: Steuertransistor
- 15: Steuer-Z-Diode
- 16: Ersatzwiderstand
- 17: Snubber-Widerstand
- 18: Snubber-Kondensator
- 20: Speicherkondensator
- 21: Treiberversorgungsanschluss
- 22: Treiberschaltung
- 23: Steuereingang (V-Gate)
- 24: Diode
- 25: Z-Diode
- 26: Widerstand
- 27: Ersatzschaltung
- 28: Umleitungsschaltung
- 29: Steuerwiderstand

## Patentansprüche

1. Elektromotor mit einer einphasigen Wicklung mit einer Energierückgewinnungsschaltung, bestehend aus zwei Teilspulen (5a, 5b) mit Mittenabgriff besteht, wobei die beiden Wicklungsenden der Teilspulen (5a, 5b) über jeweils ein über eine Treiberschaltung (22a, 22b) betriebenes Schaltelement (8a, 8b), z. B. ein Feldeffekttransistor oder ein bipolarer Transistor, mit Masse (10a, 10b) verbunden sind, wobei die Treiberschaltung (22a, 22b) über einen Steuereingang (23a, 23b) von einer Schaltungslogik gesteuert wird, wobei im Betrieb die Energierückgewinnungsschaltung dazu ausgerichtet ist, dass ein Teil der in den Teilspulen (5a, 5b) gespeicherten Energie beim Abschalten des Schaltelements (8a, 8b) über eine Diode (24a, 24b) in einen Speicherkondensator (20a, 20b) geleitet wird, welcher dadurch aufgeladen wird, wobei die zwischengespeicherte Energie des aufgeladenen Speicherkondensator (20a, 20b) eine Ausgangsspannung (21) erzeugt und wobei die Ausgangsspannung (21) als Versorgungsspannung für die Treiberschaltung dient, welche das Schaltelement (8a, 8b) ansteuert, **dadurch gekennzeichnet, dass** der Teil eines Abschaltstroms aus einer der Teilspulen (5a, 5b) der nicht über die Treiberschaltung (22a, 22b) verbraucht werden kann gesteuert über ein elektrisches Leistungsbauteil abgeleitet wird, welches parallel zu einem der Schaltelemente (8a, 8b) geschaltet ist, wobei das Leistungsbauteil ein bipolarer Leistungstransistor (13b) umfasst.

2. Energierückgewinnungsschaltung nach Anspruch 1, **dadurch gekennzeichnet, dass** das Spannungsniveau der Ausgangsspannung (21) durch eine parallel zum Speicherkondensator (20a, 20b) geschaltete Z-Diode (25a, 25b) stabilisiert wird.

3. Energierückgewinnungsschaltung nach Anspruch 1 oder 2, **dadurch gekennzeichnet, dass** die Ausgangsspannung (21) als Eingangsspannung für eine von einer Bordnetzspannung weitgehend unabhängige Anwendung, Schaltung oder Teilschaltung dient.

4. Energierückgewinnungsschaltung nach Anspruch 1, **dadurch gekennzeichnet, dass** eine Umleitungsschaltung (28b) als Leistungsbauteil vorgesehen ist, umfassend eine Steuer-Z-Diode (15b), einen Steuerwiderstand (29b), den bipolaren Leistungstransistor (13b) und einen Steuertransistor (14b).

5. Energierückgewinnungsschaltung nach einem der Ansprüche 1 bis 4, **dadurch gekennzeichnet, dass** das Leistungsbauteil eine Leistungs-Z-Diode umfasst.

6. Elektrische Kreiselpumpe mit einer Energierückgewinnungsschaltung gemäß einem der vorangehenden Ansprüche.

7. Elektrischer Ölnebelabscheider mit einer Energierückgewinnungsschaltung gemäß einem der Ansprüche 1 bis 6.

## Claims

1. Electric motor with a single-phase winding having an energy recovery circuit, consisting of two coil sections (5a, 5b) with a center tap, wherein the two winding ends of the coil sections (5a, 5b) are connected to ground (10a, 10b) via a respective switching element (8a, 8b), for example a field-effect transistor or a bipolar transistor, which is operated via a driver circuit (22a, 22b), wherein the driver circuit (22a, 22b) is controlled by a circuit logic via a control input (23a, 23b), wherein during operation the energy recovery circuit is designed such that, when the switching element (8a, 8b) is switched off, a portion of the energy stored in the coil sections (5a, 5b) is routed via a diode (24a, 24b) into a storage capacitor (20a, 20b), which is thereby charged, wherein the buffer-stored energy of the charged storage capacitor (20a, 20b) generates an output voltage (21), and wherein the output voltage (21) serves as a supply voltage for the driver circuit that actuates the switching element (8a, 8b), **characterized in that** the portion of a switch-off current from one of the coil sections (5a, 5b) that cannot be consumed via the driver circuit (22a, 22b) is diverted in a controlled manner via an electrical power component, which is connected in parallel with one of the switching elements (8a, 8b), wherein the power component comprises a bipolar power transistor (13b).

2. Energy recovery circuit according to claim 1, **characterized in that** the voltage level of the output voltage (21) is stabilized by a Zener diode (25a, 25b) connected in parallel with the storage capacitor (20a, 20b).

3. Energy recovery circuit according to claim 1 or 2, **characterized in that** the output voltage (21) serves as an input voltage for an application, circuit or subcircuit that is largely independent of an on-board power supply voltage.

4. Energy recovery circuit according to claim 1, **characterized in that** a bypass circuit (28b) is provided as the power component, comprising a control Zener diode (15b), a control resistor (29b), the bipolar power transistor (13b) and a control transistor (14b).

5. Energy recovery circuit according to any one of claims 1 to 4, **characterized in that** the power component comprises a power Zener diode.

6. Electric centrifugal pump comprising an energy recovery circuit according to any one of the preceding claims.

7. Electric oil mist separator comprising an energy recovery circuit according to any one of claims 1 to 6.

## Revendications

1. Moteur électrique avec un enroulement monophasé avec un circuit de récupération d'énergie, composé de deux bobines partielles (5a, 5b) avec prise médiane, les deux extrémités d'enroulement des bobines partielles (5a, 5b) étant reliées à la masse (10a, 10b) par l'intermédiaire d'un élément de commutation (8a, 8b) actionné par un circuit d'attaque (22a, 22b), par exemple un transistor à effet de champ ou un transistor bipolaire, le circuit d'attaque (22a, 22b) étant commandé par une logique de circuit par l'intermédiaire d'une entrée de commande (23a, 23b), le circuit de récupération d'énergie étant conçu de telle sorte qu'une partie de l'énergie stockée dans les bobines partielles (5a, 5b) est, lors de la coupure de l'élément de commutation (8a, 8b), transmise par l'intermédiaire d'une diode (24a, 24b) à un condensateur de stockage (20a, 20b) , lequel est ainsi chargé, l'énergie stockée temporairement par le condensateur de stockage chargé (20a, 20b) générant une tension de sortie (21) et la tension de sortie (21) servant de tension d'alimentation pour le circuit d'attaque qui commande l'élément de commutation (8a, 8b), **caractérisé en ce qu'**une partie du courant de coupure provenant de l'une des bobines partielles (5a, 5b) ne pouvant pas être consommée par le circuit d'attaque (22a, 22b) est dérivée de manière contrôlée par un composant de puissance électrique qui est connecté en parallèle à l'un des éléments de commutation (8a, 8b), le composant de puissance comprenant un transistor de puissance bipolaire (13b).

2. Circuit de récupération d'énergie selon la revendication 1, **caractérisé en ce que** le niveau de tension de la tension de sortie (21) est stabilisé par une diode Zener (25a, 25b) montée en parallèle avec le condensateur de stockage (20a, 20b).

3. Circuit de récupération d'énergie selon la revendication 1 ou 2, **caractérisé en ce que** la tension de sortie (21) sert de tension d'entrée pour une application, un circuit ou un sous-circuit largement indépendant d'une tension de réseau de bord.

4. Circuit de récupération d'énergie selon la revendication 1, **caractérisé en ce qu'**un circuit de dérivation (28b) est prévu en tant que composant de puissance, comprenant une diode Zener de commande (15b), une résistance de commande (29b), le transistor de puissance bipolaire (13b) et un transistor de commande (14b).

5. Circuit de récupération d'énergie selon l'une des revendications 1 à 4, **caractérisé en ce que** le composant de puissance comprend une diode Zener de puissance.

6. Pompe centrifuge électrique avec un circuit de récupération d'énergie selon l'une des revendications précédentes.

7. Séparateur de brouillard d'huile électrique avec un circuit de récupération d'énergie selon l'une des revendications 1 à 6.
